# EUROPEAN PATENT APPLICATION

(11) **EP 4 560 399 A2**
(43) Date of publication of application: **28.05.2025**
(21) Application number: 24210652.4
(22) Date of filing: 04.11.2024
(51) Int. Cl.: G03F 7/00

(54) **QUANTUM DOT PATTERNED FILM AND PREPARATION METHOD THEREOF, ELECTRON TRANSPORT LAYER, AND QUANTUM DOT ELECTROLUMINESCENT DEVICE**

(30) Priority: 21.11.2023 CN 202311552559
(71) Applicant: Leyard Optoelectronic Co., Ltd., Beijing 100091 (CN)
(72) Inventor: LI, Jun, Beijing, 100091 (CN); YANG, Xiaoyu, Beijing, 100091 (CN); MA, Li, Beijing, 100091 (CN); LU, Changjun, Beijing, 100091 (CN)
(74) Representative: HGF

(57) **Abstract**

The present disclosure provides quantum dot patterned film and preparation method thereof, electron transport layer, and quantum dot electroluminescent device. The preparation method includes: S1, attaching a quantum dot precursor solution to a functional transport layer substrate to obtain a wet film having a quantum dot layer; S2, attaching a photosensitive ligand to a patterned surface of a prefabricated nano stamp to obtain a photosensitive ligand stamp having a ligand layer; S3, contacting the quantum dot layer of the wet film with the ligand layer of the photosensitive ligand stamp, performing imprinting treatment, so as to obtain a ligand exchange quantum dot film; and S4, performing on the ligand exchange quantum dot film to obtain the quantum dot patterned film. The preparation method solves the problems in the related art that the preparation process of the quantum dot patterned film is complex and the production yield is relatively low.

## Description

### Technical Field

The present disclosure relates to the technical field of quantum dot luminescent devices, and in particular to quantum dot patterned film and preparation method thereof, electron transport layer, and quantum dot electroluminescent device.

### Background

As a new generation of luminescent materials in the field of display, quantum dots have the advantages of low cost, wide color gamut, and high color purity, and have attracted widespread attention in related fields. Photoluminescence technology based on quantum dot materials has been successfully applied to the field of display lighting and has achieved good feedback on product applications. However, due to the limitations of the quantum dot materials and patterning processing technology, quantum dot electroluminescent technology (Quantum Dot Light Emitting Diode (QLED)) is currently facing difficulties in industrial application. Patterning the entire surface of a solution-coated quantum dot luminescent film into a small unit array is a prerequisite for the application of quantum dot electroluminescence in the field of display. Therefore, the development of efficient and lossless quantum dot patterning methods is a key direction for the development of the current field.

The mainstream quantum dot patterning technology is mainly classified into two categories: nanoimprint technology and photolithography technology. The nanoimprint technology is to perform imprinting treatment on a quantum dot wet film under a certain pressure through a prepared patterned stamp, and the quantum dot film forms a pattern under the action of an imprinting force. However, this method has relatively high requirements for the viscosity of the wet film, the surface wettability of the stamp, the imprinting force, etc., and easily causes quantum dot residues at an imprinted position in actual production, resulting in the final patterned structure not being clear and complete. The photolithography technology combines photosensitive ligands with the quantum dots. Generally, ligand exchange or mixing occurs in a quantum dot precursor solution, then the quantum dots containing the photosensitive ligands are coated into a thin film, and a patterned mask is used for photolithography, so that the photosensitive ligands are photocrosslinked by light, and the solubility of the quantum dots in a light-receiving area is changed, thereby obtaining a patterned quantum dot film through development. This method is the most widely used and may obtain a better quantum dot pattern, but the photosensitive ligands in the quantum dot film usually affect the subsequent operation of the device, and an insulating organic structure thereof may affect carrier transport or capture a carrier as a recombination center. Therefore, the two current mainstream methods have respective disadvantages, and there is an urgent need to develop a high-precision lossless quantum dot patterning method to achieve an efficient QLED array display device.

### Summary

A main objective of the present disclosure is to provide quantum dot patterned film and preparation method thereof, electron transport layer, and quantum dot electroluminescent device, so as to solve the problems in the related art that the preparation process of the quantum dot patterned film is complex and the production yield is relatively low.

In order to achieve the above objective, according to one aspect of the present disclosure, a preparation method of a quantum dot patterned film is provided. The preparation method includes: S1, attaching a quantum dot precursor solution to a functional transport layer substrate to obtain a wet film having a quantum dot layer; S2, attaching a photosensitive ligand to a patterned surface of a prefabricated nano stamp to obtain a photosensitive ligand stamp having a ligand layer; S3, contacting the quantum dot layer of the wet film with the ligand layer of the photosensitive ligand stamp, performing imprinting treatment, and removing the stamp after completing the imprinting treatment, so as to obtain a ligand exchange quantum dot film; and S4, sequentially performing exposure treatment and development treatment on the ligand exchange quantum dot film to obtain the quantum dot patterned film.

Further, the pressure of the imprinting treatment is 0 MPa-100 MPa, and/or the time of the imprinting treatment is 1 min-20 min.

Further, the preparation method further includes: performing first annealing treatment on a system subjected to the imprinting treatment during or after the imprinting treatment process, and/or the temperature of the first annealing treatment being 50 °C-300 °C, and/or the time of the first annealing treatment being 1 min-5 min.

Further, the preparation method further includes a process of performing modification treatment on the prefabricated nano stamp by using an ultraviolet-ozone cleaning process, where the modification treatment is performed at a power of 55 W-100 W by using ultraviolet wavelengths of 254 nm and 185 nm, and/or the time of the modification treatment is 10 min-30 min; and/or the material of the prefabricated nano stamp is selected from any one or more of Polydimethylsiloxane (PDMS), Polymethyl Methacrylate (PMMA), and sapphire Al₂O₃.

Further, the thickness of the ligand layer is 5 nm-100 nm, and/or a thickness ratio of the quantum dot layer to the ligand layer is 10-80: 5-100; and/or the material of the functional transport layer substrate is selected from any one or more of transparent conductive glass, an oxide material, and an organic polymer material; and/or quantum dots in the quantum dot precursor solution are selected from any one or more of group II-VI quantum dots, group III-V quantum dots, and perovskite quantum dots.

Further, the preparation method further includes: performing second annealing treatment on the ligand exchange quantum dot film between the exposure treatment and the development treatment, and/or the temperature of the second annealing treatment being 100 °C-150 °C, and/or the time of the second annealing treatment being 1 min-10 min; and/or performing the exposure treatment by using ultraviolet light with a wavelength of less than 480 nm, and/or the time of the exposure treatment being 10 min-30 min.

Further, the photosensitive ligand is a ligand compound that generates free radicals at an ultraviolet wavelength of less than 380 nm, and the photosensitive ligand is a benzophenone-based photosensitive molecular compound and/or a photogenerated nitrene molecular compound.

According to another aspect of the present disclosure, a quantum dot patterned film is provided. The quantum dot patterned film is prepared by the above preparation method.

According to still another aspect of the present disclosure, an electron transport layer is provided, including a quantum dot film. The quantum dot film is the above quantum dot patterned film.

According to still another aspect of the present disclosure, a quantum dot electroluminescent device is provided, including an electron transport layer. The electron transport layer is the above electron transport layer.

Applying the technical solution of the present disclosure, in the above preparation method, the functional transport layer substrate is first coated with the quantum dot precursor solution to ensure a state of the wet film thereof, and at the same time, the prefabricated nano stamp is coated with photosensitive ligand molecules. At this time, the photosensitive ligand molecules are deposited on both a protruding part and a recessed part of the stamp. Then the quantum dot wet film and the photosensitive ligand stamp having a pattern are contacted and imprinted. This process basically does not require additional pressure or only applies slight pressure to ensure sufficient contact. After the imprinting treatment, the photosensitive ligand diffuses reasonably in the quantum dot wet film in the imprinting area, and the ligand exchange process is completed. Then the nano stamp is removed, and exposure treatment is performed on the entire quantum dot film. The ligand exchange area is exposed to light to produce free radical reactions such as photocrosslinking, so that crosslinking and solubility changes occur between the quantum dots in this area. Then, through the development treatment, the quantum dot patterned film is obtained.

Compared with a simple nanoimprint patterning method, the preparation method of the present disclosure makes full use of the characteristics that the ligand on the surface of the quantum dot material is exchangeable and the solution may be imprinted and shaped. The pattern provided by the nanoimprint stamp is cleverly combined with the photosensitive ligand for modification without the need to use additional imprinting force and the process of mixing the photosensitive ligand with the quantum dot, thereby avoiding the necessary steps of mixing the quantum dot film with the ligand in the conventional process, and improving the purity of the quantum dot film and the performance of the device. Localized ligand exchange is achieved in the contact process, so that the local solubility difference of the quantum dot film is achieved through photocrosslinking, and then the high-precision lossless pure quantum dot pattern film is obtained through development. This method does not need to dope the insulating photosensitive ligand in the quantum dot. Since there is no photosensitive ligand in the quantum dot luminescent film obtained by this method, the performance of the electroluminescent device thereof remains almost unchanged. The above technology is not limited to the type of the quantum dot ligands, may be compatible with the preparation of efficient devices and achieve good carrier transport, and does not lose the performance of the device in the patterning process.

### Brief Description of the Drawings

The drawings of the specification, which constitute a part of the present disclosure, are intended to provide a further understanding of the present disclosure, and the exemplary embodiments of the present disclosure and the description thereof are intended to explain the present disclosure and do not constitute an undue limitation on the present disclosure. In the drawings:

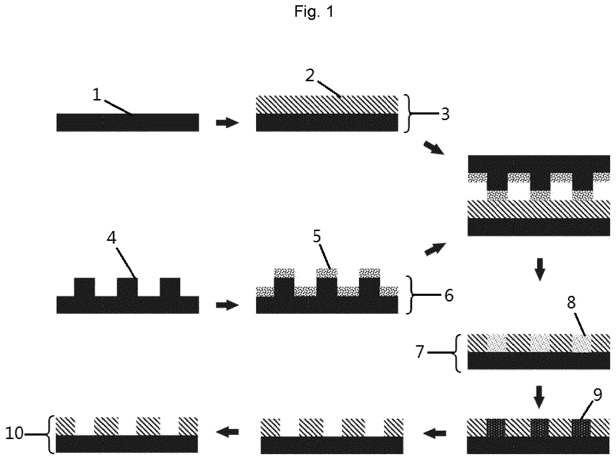

Fig. 1 shows a flowchart of a preparation process of a quantum dot patterned film according to Embodiment 1 of the present disclosure.

Herein, the above drawings include the following reference signs.
1. Functional transport layer substrate; 2. Quantum dot layer; 3. Wet film; 4. Prefabricated nano stamp; 5. Ligand layer; 6. Photosensitive ligand stamp; 7. Ligand exchange quantum dot film; 8. Photosensitive ligand-quantum dot; 9. Photocrosslinked quantum dot; 10. Quantum dot patterned film.

### Detailed Description of the Embodiments

It is to be noted that the embodiments in the present disclosure and features in the embodiments may be combined with each other without conflict. The present disclosure is described below with reference to the drawings and in conjunction with the embodiments in detail.

As analyzed in the background art, the conventional nanoimprinting method cannot avoid the residue problem, and the main phenomenon is that the imprinting process requires fine control of pressure to avoid the growth of unwanted quantum dot residues at a non-preset pattern position; at the same time, the peeling of a nano stamp may also affect the quality and yield of a pattern, so that the peeling process is likely to reduce the yield of the final pattern, and the whole process is relatively complicated; and the conventional photolithography technology requires mixing a photosensitive ligand with a quantum dot, resulting in the final quantum dot luminescent pattern containing the insulating ligand, which affects the performance of an electroluminescent device. It can be seen that the present disclosure provides quantum dot patterned film and preparation method thereof, electron transport layer, and quantum dot electroluminescent device, so as to solve the problems in the related art that the preparation process of the quantum dot patterned film is complex and the production yield is relatively low.

In one typical implementation of the present disclosure, a preparation method of a quantum dot patterned film is provided. As shown in Fig. 1, the preparation method includes: S1, attaching a quantum dot precursor solution to a functional transport layer substrate 1 to obtain a wet film 3 having a quantum dot layer 2; S2, attaching a photosensitive ligand to a patterned surface of a prefabricated nano stamp 4 to obtain a photosensitive ligand stamp 6 having a ligand layer 5; S3, contacting the quantum dot layer of the wet film with the ligand layer of the photosensitive ligand stamp, performing imprinting treatment, and removing the stamp after completing the imprinting treatment, so as to obtain a ligand exchange quantum dot film 7; and S4, sequentially performing exposure treatment and development treatment on the ligand exchange quantum dot film to obtain the quantum dot patterned film 10.

According to the above preparation method, the functional transport layer substrate is first coated with the quantum dot precursor solution to ensure a state of the wet film thereof, and at the same time, the prefabricated nano stamp is coated with photosensitive ligand molecules. At this time, the photosensitive ligand molecules are deposited on both a protruding part and a recessed part of the stamp. Then the quantum dot wet film and the photosensitive ligand stamp having a pattern are contacted and imprinted. This process basically does not require additional pressure or only applies slight pressure to ensure sufficient contact. After the imprinting treatment, the photosensitive ligand diffuses reasonably in the quantum dot wet film in the imprinting area, and the ligand exchange process is completed. Then the nano stamp is removed, and exposure treatment is performed on the entire quantum dot film. The ligand exchange area is exposed to light to produce free radical reactions such as photocrosslinking, so that crosslinking and solubility changes occur between the quantum dots in this area. Then, through the development treatment, the quantum dot patterned film is obtained.

Compared with a simple nanoimprint patterning method, the preparation method of the present disclosure makes full use of the characteristics that the ligand on the surface of the quantum dot material is exchangeable and the solution may be imprinted and shaped. The pattern provided by the nanoimprint stamp is cleverly combined with the photosensitive ligand for modification without the need to use additional imprinting force and the process of mixing the photosensitive ligand with the quantum dot, thereby avoiding the necessary steps of mixing the quantum dot film with the ligand in the conventional process, and improving the purity of the quantum dot film and the performance of the device. Localized ligand exchange is achieved in the contact process, so that the local solubility difference of the quantum dot film is achieved through photocrosslinking, and then the high-precision lossless pure quantum dot pattern film is obtained through development. This method does not need to dope the insulating photosensitive ligand in the quantum dot. Since there is no photosensitive ligand in the quantum dot luminescent film obtained by this method, the performance of the electroluminescent device thereof remains almost unchanged. The above technology is not limited to the type of the quantum dot ligands, may be compatible with the preparation of efficient devices and achieve good carrier transport, and does not lose the performance of the device in the patterning process.

In one embodiment of the present disclosure, the pressure of the imprinting treatment is 0 MPa-100 MPa, and/or the time of the imprinting treatment is 1 min-20 min.

The pressure applied in the above nanoimprinting method may usually be adjusted according to parameters such as different photosensitive ligands, quantum dot composition, viscosity of the wet film, etc., preferably within the above range to be conductive to ensuring that the quantum dot layer of the wet film is in sufficient contact with the ligand layer of the photosensitive ligand stamp.

In one embodiment of the present disclosure, the preparation method further includes: performing first annealing treatment on a system subjected to the imprinting treatment during or after the imprinting treatment process, and/or the temperature of the first annealing treatment being 50 °C-300 °C, and/or the time of the first annealing treatment being 1 min-5 min.

For different photosensitive ligand films and wet film conditions, the first annealing treatment is usually performed on the system subjected to the imprinting treatment during or after the imprinting treatment process, which is conductive to accelerating the migration of the photosensitive ligand to the wet film and completing the ligand exchange to obtain a photosensitive ligand-quantum dot 8. The above preferred temperature and time of the first annealing treatment are conductive to taking into account the efficiency and effect of ligand exchange under different wet film conditions.

In one embodiment of the present disclosure, the preparation method further includes a process of performing modification treatment on the prefabricated nano stamp by using an ultraviolet-ozone cleaning process, where the modification treatment is performed at a power of 55 W-100 W by using ultraviolet wavelengths of 254 nm and 185 nm, and/or the time of the modification treatment is 10 min-30 min; and/or the material of the prefabricated nano stamp is selected from any one or more of PDMS, PMMA, and sapphire Al₂O₃.

The pattern surface of the prefabricated nano stamp should meet certain wettability to ensure that the coated photosensitive ligand film is sufficiently uniform. The above preferred ultraviolet-ozone cleaning process is conductive to modifying the surface of the pattern of the prefabricated nano stamp, and the further preferred time of the modification treatment is conductive to sufficient modification of a modifier for the surface of the pattern of the prefabricated nano stamp, thereby improving the wettability thereof. In addition, the pattern preparation method of the stamp may use common pattern etching preparation processes such as photolithography and electron beam etching, which will not be elaborated herein.

In one embodiment of the present disclosure, the thickness of the ligand layer is 5 nm to 100 nm, and/or a thickness ratio of the quantum dot layer to the ligand layer is 10-80: 5-100; and/or the material of the functional transport layer substrate is selected from any one or more of transparent conductive glass, an oxide material, and an organic polymer material; further, the transparent conductive glass is preferably selected from any one or more of Indium Tin Oxide (ITO), Fluorine-doped Tin Oxide (FTO), and Indium Zinc Oxide (IZO), the oxide material is preferably selected from any one or more of Al₂O₃, TiO₂, SnO₂, and ZnO, and the organic polymer material is preferably PMMA and/or PDMS; and/or quantum dots in the quantum dot precursor solution are selected from any one or more of group II-VI quantum dots, group III-V quantum dots, and perovskite quantum dots; and further, the quantum dots are preferably selected from any one or more of CdS, CdSe, ZnS, ZnSe, InP, CsPbI₃, and CsPbBr₃.

The above preferred thickness of the ligand layer and the thickness ratio of the quantum dot layer to the ligand layer are within the above range, which is conducive to sufficient ligand exchange between the quantum dot and the photosensitive ligand. The material of the functional transport layer substrate includes, but is not limited to, one or more of various insulating, semiconductor and other organic or inorganic materials, as well as a series of composite materials. The material of the functional transport layer substrate should meet good wettability to ensure that the quantum dots thereon may obtain a uniform and dense film. In order to further prefer a functional transport layer substrate with good wettability, the above types of transparent conductive glass, oxide materials, and organic polymer materials are preferred. In addition, in order to meet the subsequent preparation of an optoelectronic device, the above functional transport layer substrate may be of a pre-prepared device structure.

The above quantum dots include, but are not limited to, quantum dots based on compound materials such as group II-VI, group III-V, and perovskite. The preferred types of quantum dots are more conducive to exerting the ligand exchange process with the photosensitive ligand. The luminescent wavelength of the quantum dots is not limited, and a coating method of attaching the quantum dot precursor solution to the functional transport layer substrate includes, but is not limited to, a spin coating method, a scraping method, a slit coating method, an inkjet printing method, etc.

In one embodiment of the present disclosure, the preparation method further includes: performing second annealing treatment on the ligand exchange quantum dot film between the exposure treatment and the development treatment, and/or the temperature of the second annealing treatment being 100°C-150°C, and/or the time of the second annealing treatment being 1 min-10 min; and/or performing the exposure treatment by using ultraviolet light with a wavelength of less than 480 nm, and/or the time of the exposure treatment being 10 min-30 min.

The ultraviolet light with the above preferred wavelength and the time of the exposure treatment to adapting the photosensitive ligand to obtain the photocrosslinked quantum dots 9, thereby improving the efficiency and effect of the exposure treatment. The second annealing treatment and the control of the temperature and time thereof are conductive to improving the stability of the quantum dot patterned film, thereby preventing the accidental shedding of the film during the subsequent solvent development treatment process.

In one embodiment of the present disclosure, the photosensitive ligand is a ligand compound that generates free radicals at an ultraviolet wavelength of less than 380 nm, preferably, the photosensitive ligand is a benzophenone-based photosensitive molecular compound and/or a photogenerated nitrene molecular compound.

The above preferred photosensitive ligand is an organic molecular compound containing carbonyl, amino and other groups, which generates the free radicals at the ultraviolet wavelength of less than 380 nm and undergoes molecular-level crosslinking, such as benzophenone-based photosensitive molecular series and/or photogenerated nitrene molecular series. It is to be noted that the photosensitive ligand molecule should have a ligand group with relatively high solubility in poor solvents of the quantum dots, such as amino, carboxyl, benzene ring groups, etc. The coating preparation method of the photosensitive ligand film includes, but is not limited to, a spin coating method, a blade coating method, a slit coating method, a vacuum evaporation method, etc.

In addition, during the development treatment process, the solvent should be a poor solvent for the quantum dots with high solubility for the photosensitive ligand. During the washing process, only the quantum dots in the crosslinked area of the photosensitive ligand are washed away, and the quantum dots in the remaining area are not washed by a developing solvent. The washing process is guaranteed to be performed at room temperature. The washing manner is to spin coat the quantum dot film at 3000 rpm/s-10000 rpm/s, and drip the solvent for washing during the spin coating process, which may effectively achieve the integrity of the pattern and ensure no residue.

In another typical implementation of the present disclosure, a quantum dot patterned film is provided. The quantum dot patterned film is prepared by the above preparation method.

Thanks to the innovative design of the present disclosure, "imprint lithography" quantum dot patterning technology achieves a lossless and high-efficiency quantum dot patterned film. This method is based on two processes of nanoimprinting and photolithography. By modifying and depositing a photosensitive ligand on a stamp and imprinting same on a quantum dot film, the quantum dot ligand exchange at an imprinted position is achieved in a reasonable environment. The imprinted position is a quantum dot with the photosensitive ligand, and a non-imprinted position is a conventional ligand quantum dot. After a further conventional photolithography process, the quantum dot patterned film may be achieved. Compared with a simple nanoimprint patterning method, this method does not require pressurization and has no obvious imprint residue problem. Compared with a simple photolithography patterning method, this method does not need to dope the insulating photosensitive ligand in the quantum dot. Since there is no photosensitive ligand in the quantum dot luminescent film obtained by this method, the performance of the electroluminescent device thereof remains almost unchanged.

In still another typical implementation of the present disclosure, an electron transport layer is provided, including a quantum dot film. The quantum dot film is the above quantum dot patterned film.

Thanks to the high-quality quantum dot film prepared in the present disclosure, the electron transport layer having the above quantum dot film has excellent electron transport properties.

In still another typical implementation of the present disclosure, a quantum dot electroluminescent device is provided, including an electron transport layer. The electron transport layer is the above electron transport layer.

The quantum dot electroluminescent device including the electron transport layer of the present disclosure, thanks to the patterning process, ensures high precision and integrity of a quantum dot pattern, while retaining the luminescence performance of quantum dots, thereby improving the performance of the quantum dot electroluminescent device.

The beneficial effects of the present disclosure are described below in conjunction with specific embodiments and comparative examples.

### Embodiment 1

A CdSe/CdS quantum dot patterned film and a Light Emitting Diode (LED) device were prepared.

The CdSe/CdS quantum dot patterned film was prepared according to a flowchart of a preparation process of the quantum dot patterned film shown in Fig. 1.

At S1, a CdSe/CdS wet film was prepared. 15 mg·mL⁻¹ of a CdSe/CdS quantum dot solution was spin-coated onto an ITO/PEDOT:PSS/TFB transparent conductive substrate. The resistance of ITO conductive glass was about 20 Ω·sq⁻¹. A PEDOT:PSS solution (Baytron PVP Al 4083 ) was spin-coated onto the cleaned ITO conductive glass at a rate of 3000 rpm, followed by annealing at 150°C for 30 minutes to complete the preparation. 8 mg·mL⁻¹ of a TFB chlorobenzene solution was spin-coated onto PEDOT:PSS at a rate of 2000 rpm and a spin coating parameter of 45 s, followed by annealing at 150 °C for 30 minutes to complete the preparation. The CdSe/CdS quantum dot solution was spin-coated onto a TFB film at spin coating parameters of 2000 rpm and 30 s to complete the preparation of the CdSe/CdS wet film, where the thickness of the quantum dot layer was 50 nm.

At S2, a photosensitive ligand stamp was prepared, and modification treatment was performed on a surface of a prefabricated nano stamp by using an ultraviolet-ozone cleaner to obtain a modified stamp, where the power was 55 W, the ultraviolet wavelengths were 254 nm and 185 nm, and the time of the modification treatment was 20 min. 0.5 M of a benzophenone-based photosensitive molecule solution was spin-coated onto the surface of the modified stamp, where the spin coating parameters were 2000 rpm and 60 s, and the spin coating environment was a yellow light environment that filters ultraviolet light. After spin coating, a solvent was pumped out by a vacuum chamber, and the vacuum was evacuated for about 10 min to complete the preparation of the photosensitive ligand stamp, where the thickness of the ligand layer was 80 nm.

At S3, nanoimprinting was performed. A substrate coated with the CdSe/CdS quantum dot wet film was in contact with a nano stamp coated with benzophenone-based photosensitive molecules, and a pressure of 0.5 MPa was applied for 1 min. Then, the imprinted film was annealed at 100°C for 5 min. Both the imprinting and annealing processes were to ensure the molecular migration and ligand exchange of the photosensitive molecules to the quantum dot wet film. After the annealing was completed, the nano stamp was separated from the substrate to obtain a quantum dot film containing photosensitive ligands in a local area.

At S4, photolithography and development were performed. The quantum dot film containing the local photosensitive ligands was irradiated under 375 nm ultraviolet light for 10 min to complete the photocrosslinking of the ligands. The film with different solubility of quantum dots in the local area was completed by annealing treatment at 100 °C for 5 min; and then a total of 100 µL of a mixed solvent of DMF:CB (1:5) was used for drip coating, cleaning and development of the film at a speed of 5000 rpm to clean the quantum dots in the photocrosslinked area, so as to obtain a patterned quantum dot film.

At S5, the LED device based on the CdSe/CdS patterned film was prepared. 0.1 M of CH₃(CH₂)₁₇SiCl₃ silane was spin-coated on the CdSe/CdS patterned film to construct an insulating layer, and then 30 mg·mL⁻¹ of Zn_{0.85}Mg_{0.15}O ethanol was deposited on the patterned quantum dot film at a speed of 2000 rpm, followed by annealing at 85 °C for 30 min to obtain an electron transport layer, and then 100 nm of Al was evaporated as a driving electrode to complete the preparation of a patterned CdSe/CdS green LED device.

### Embodiment 2

The difference from Embodiment 1 was that the CdSe/CdS quantum dot film might be replaced with MAPbI₃ quantum dots in S1 to achieve the preparation of a red perovskite patterned film and an LED device.

### Embodiment 3

The difference from Embodiment 1 was that the entire Au electrode might be replaced with a driving electrode having a corresponding pattern in S5, thereby further achieving a quantum dot Micro-QLED device with a controllable driving circuit.

### Embodiment 4

The difference from Embodiment 1 was that the ITO conductive glass might be replaced with an ITO/PEN flexible conductive substrate in S1, thereby achieving a patterned quantum dot flexible LED luminescent device.

### Embodiment 5

The difference from Embodiment 1 was that the pressure of the nanoimprinting process in S3 was 0 MPa, and finally the patterned CdSe/CdS green LED device was obtained.

### Embodiment 6

The difference from Embodiment 1 was that the pressure of the nanoimprinting process in S3 was 100 MPa, and finally the patterned CdSe/CdS green LED device was obtained.

### Embodiment 7

The difference from Embodiment 1 was that the temperature of the annealing treatment in the nanoimprinting process in S3 was 300 °C, and finally the patterned CdSe/CdS green LED device was obtained.

### Embodiment 8

The difference from Embodiment 1 was that annealing treatment was not performed during the nanoimprinting process in S3, and finally the patterned CdSe/CdS green LED device was obtained.

### Embodiment 9

The difference from Embodiment 1 was that when the photosensitive ligand stamp was prepared in S2, the power of the ultraviolet-ozone cleaner was 100 W, and finally the patterned CdSe/CdS green LED device was obtained.

### Embodiment 10

The difference from Embodiment 1 was that when the photosensitive ligand stamp was prepared in S2, modification treatment was not performed on the prefabricated nano stamp, and finally the patterned CdSe/CdS green LED device was obtained.

### Embodiment 11

The difference from Embodiment 1 was that when the photosensitive ligand stamp was prepared in S2, the time of the modification treatment was 30 min, and finally the patterned CdSe/CdS green LED device was obtained.

### Embodiment 12

The difference from Embodiment 1 was that the thickness ratio of the quantum dot layer to the ligand layer was 30: 100, and finally the patterned CdSe/CdS green LED device was obtained.

### Embodiment 13

The difference from Embodiment 1 was that the photosensitive ligand was (1E, 4E)-1,5-bis(4-azido-2,3,5,6-tetrafluorophenyl)penta-1,4-diene-3-one, and finally the patterned CdSe/CdS green LED device was obtained.

### Embodiment 14

The difference from Embodiment 1 was that annealing treatment was not performed in the photolithography and development processes in S4, and finally the patterned CdSe/CdS green LED device was obtained.

### Embodiment 15

The difference from Embodiment 1 was that the temperature of the annealing treatment in the photolithography and development processes in S4 was 150 °C, and finally the patterned CdSe/CdS green light LED device was obtained.

### Comparative Embodiment 1

The difference from Embodiment 1 was that no photosensitive ligand and photolithography process were required, the conventional nanoimprinting method was directly used for patterning, the pressure applied to the stamp during the imprinting process was 10 MPa, and finally the patterned CdSe/CdS green LED device was obtained.

### Comparative Embodiment 2

The difference from Embodiment 1 was that no additional stamp and imprinting treatment were used, the quantum dots were directly mixed with the photosensitive ligand, the quantum dot pattern was obtained by photolithography and development by using a mask, and finally the patterned CdSe/CdS green light LED device was obtained.

The yield of the quantum dot patterned thin film and the luminous efficiency of the luminescent device prepared in the above embodiments and comparative embodiments were statistically analyzed, and the test results were listed in Table 1.

**Table 1**

| Embodiment/Comparative Example | Yield/% | Luminous efficiency/% |
|---|---|---|
| Embodiment 1 | 95 | 19 |
| Embodiment 2 | 92 | 15 |
| Embodiment 3 | 80 | 17 |
| Embodiment 4 | 85 | 15 |
| Embodiment 5 | 88 | 18 |
| Embodiment 6 | 86 | 18 |
| Embodiment 7 | 94 | 17 |
| Embodiment 8 | 80 | 16 |
| Embodiment 9 | 96 | 19 |
| Embodiment 10 | 75 | 18 |
| Embodiment 11 | 96 | 19 |
| Embodiment 12 | 95 | 18 |
| Embodiment 13 | 90 | 18 |
| Embodiment 14 | 93 | 16 |
| Embodiment 15 | 92 | 17 |
| Comparative Embodiment 1 | 60 | 18 |
| Comparative Embodiment 2 | 60 | 15 |

From the above description, it might be seen that the above embodiments of the present disclosure achieve the following technical effects.

According to the above preparation method, the functional transport layer substrate was first coated with the quantum dot precursor solution to ensure a state of the wet film thereof, and at the same time, the prefabricated nano stamp was coated with photosensitive ligand molecules. At this time, the photosensitive ligand molecules were deposited on both a protruding part and a recessed part of the stamp. Then the quantum dot wet film and the photosensitive ligand stamp having a pattern were contacted and imprinted. This process basically did not require additional pressure or only applied slight pressure to ensure sufficient contact. After the imprinting treatment, the photosensitive ligand diffused reasonably in the quantum dot wet film in the imprinting area, and the ligand exchange process was completed. Then the nano stamp was removed, and exposure treatment was performed on the entire quantum dot film. The ligand exchange area was exposed to light to produce free radical reactions such as photocrosslinking, so that crosslinking and solubility changes occurred between the quantum dots in this area. Then, through the development treatment, the quantum dot patterned film was obtained.

Compared with a simple nanoimprint patterning method, the preparation method of the present disclosure made full use of the characteristics that the ligand on the surface of the quantum dot material was exchangeable and the solution might be imprinted and shaped. The pattern provided by the nanoimprint stamp was cleverly combined with the photosensitive ligand for modification without the need to use additional imprinting force and the process of mixing the photosensitive ligand with the quantum dot, thereby avoiding the necessary steps of mixing the quantum dot film with the ligand in the conventional process, and improving the purity of the quantum dot film and the performance of the device. Localized ligand exchange was achieved in the contact process, so that the local solubility difference of the quantum dot film was achieved through photocrosslinking, and then the high-precision lossless pure quantum dot pattern film was obtained through development. This method did not need to dope the insulating photosensitive ligand in the quantum dot. Since there was no photosensitive ligand in the quantum dot luminescent film obtained by this method, the performance of the electroluminescent device thereof remained almost unchanged. The above technology was not limited to the type of the quantum dot ligands, might be compatible with the preparation of efficient devices and achieve good carrier transport, and did not lose the performance of the device in the patterning process.

## Claims

1. A preparation method of a quantum dot patterned film, comprising:
S1, attaching a quantum dot precursor solution to a functional transport layer substrate to obtain a wet film having a quantum dot layer;
S2, attaching a photosensitive ligand to a patterned surface of a prefabricated nano stamp to obtain a photosensitive ligand stamp having a ligand layer;
S3, contacting the quantum dot layer of the wet film with the ligand layer of the photosensitive ligand stamp, performing imprinting treatment, and removing the stamp after completing the imprinting treatment, so as to obtain a ligand exchange quantum dot film; and
S4, sequentially performing exposure treatment and development treatment on the ligand exchange quantum dot film to obtain the quantum dot patterned film.

2. The preparation method according to claim 1, wherein the pressure of the imprinting treatment is 0 MPa-100 MPa, and/or the time of the imprinting treatment is 1 min-20 min.

3. The preparation method according to claim 1 or 2, wherein the preparation method further comprises: performing first annealing treatment on a system subjected to the imprinting treatment during or after the imprinting treatment process, and/or the temperature of the first annealing treatment being 50 °C-300 °C, and/or the time of the first annealing treatment being 1 min-5 min.

4. The preparation method according to claim 1 or 2, wherein the preparation method further comprises:
a process of performing modification treatment on the prefabricated nano stamp by using an ultraviolet-ozone cleaning process;
wherein the modification treatment is performed at a power of 55 W-100 W by using ultraviolet wavelengths of 254 nm and 185 nm, and/or the time of the modification treatment is 10 min-30 min;
and/or the material of the prefabricated nano stamp is selected from any one or more of Polydimethylsiloxane (PDMS), Polymethyl Methacrylate (PMMA), and sapphire Al₂O₃.

5. The preparation method according to claim 1 or 2, wherein the thickness of the ligand layer is 5 nm-100 nm, and/or a thickness ratio of the quantum dot layer to the ligand layer is 10-80: 5-100; and/or the material of the functional transport layer substrate is selected from any one or more of transparent conductive glass, an oxide material, and an organic polymer material;
and/or quantum dots in the quantum dot precursor solution are selected from any one or more of group II-VI quantum dots, group III-V quantum dots, and perovskite quantum dots.

6. The preparation method according to claim 1 or 2, wherein the preparation method further comprises: performing second annealing treatment on the ligand exchange quantum dot film between the exposure treatment and the development treatment, and/or the temperature of the second annealing treatment being 100 °C-150 °C, and/or the time of the second annealing treatment being 1 min-10 min; and/or performing the exposure treatment by using ultraviolet light with a wavelength of less than 480 nm, and/or the time of the exposure treatment being 10 min-30 min.

7. The preparation method according to claim 1 or 2, wherein the photosensitive ligand is a ligand compound that generates free radicals at an ultraviolet wavelength of less than 380 nm, and the photosensitive ligand is a benzophenone-based photosensitive molecular compound and/or a photogenerated nitrene molecular compound.

8. A quantum dot patterned film, wherein the quantum dot patterned film is prepared by the preparation method according to any one of claims 1 to 7.

9. An electron transport layer, comprising a quantum dot film, wherein the quantum dot film is the quantum dot patterned film according to claim 8.

10. A quantum dot electroluminescent device, comprising an electron transport layer, wherein the electron transport layer is the electron transport layer according to claim 9.

11. The preparation method according to claim 5, wherein the transparent conductive glass is selected from any one or more of Indium Tin Oxide, Fluorine-doped Tin Oxide and Indium Zinc Oxide.

12. The preparation method according to claim 5, wherein the oxide material is selected from any one or more of Al₂O₃, TiO₂, SnO₂, and ZnO.

13. The preparation method according to claim 5, wherein the organic polymer material is preferably PMMA and/or PDMS.

14. The preparation method according to claim 5, wherein the quantum dots are selected from any one or more of CdS, CdSe, ZnS, ZnSe, InP, CsPbI₃ and CsPbBr₃.

15. The preparation method according to claim 1, wherein the preparation method further comprises: washing the quantum dot film, the washing process is guaranteed to be performed at room temperature; and/or the washing manner is to spin coat the quantum dot film at 3000 rpm/s-10000 rpm/s.
